# FASCICULE DE BREVET EUROPEEN

(11) **EP 0 790 503 B1**
(45) Date de publication et mention de la délivrance du brevet: **09.10.2002**
(21) Numéro de dépôt: 97400313.9
(22) Date de dépôt: 12.02.1997
(51) Int. Cl.: G01R 21/01, H03G 3/20

(54) **Dispositif de mesure de puissance radiofréquence**
Hochfrequenz-Leistungsmesseinrichtung
Radiofrequency power measuring device

(30) Priorité: 15.02.1996 FR 9601878
(43) Date de publication de la demande: 20.08.1997
(73) Titulaire: NORTEL NETWORKS France, 78117 Châteaufort (FR)
(72) Inventeur: Ly, Daravan, 94120 Fontenay Sous Bois (FR)
(74) Mandataire: Loisel, Bertrand

(56) Documents cités:
- EP-A- 0 404 294
- EP-A- 0 480 333
- EP-A- 0 604 203
- US-A- 5 363 071
- INTERNATIONAL MICROWAVE SYMPOSIUM, LONG BEACH, JUNE 13 - 15, 1989, vol. 1, 13 Juin 1989, INSTITUTE OF ELECTRICAL AND ELECTRONICS ENGINEERS, pages 329-332, XP000077177 EMERY T ET AL: "ANALYSIS AND DESIGN OF IDEAL NON SYMMETRICAL COUPLED MICROSTRIP DIRECTIONAL COUPLERS"
- IEEE TRANSACTIONS ON MICROWAVE THEORY AND TECHNIQUES, vol. 35, no. 8, Août 1987, NEW YORK US, pages 719-725, XP002016953 P.K.IKÄLÄINEN ET AL.: "Wide-Band, Forward-Coupling Microstrip Hybrids with High Directivity"

## Description

La présente invention concerne la mesure de la puissance de signaux radiofréquence (RF).

L'invention a notamment des applications dans les étages d'amplification d'émetteurs radio à large bande. L'amplificateur de puissance attaquant l'antenne d'un émetteur radio a généralement son gain asservi de façon que sa puissance de sortie corresponde à une valeur de consigne fixe ou réglable. L'asservissement nécessite généralement une mesure de la puissance délivrée par l'amplificateur, effectuée en prélevant un signal de mesure au moyen d'un coupleur en sortie de l'amplificateur. Le coupleur doit présenter un rapport directivité/couplage relativement élevé pour que les mesures aient une bonne précision. Cette contrainte est problématique puisque les coupleurs les plus intéressants économiquement, à savoir les coupleurs réalisés en technologie « microstrip », ont une directivité qui se dégrade fortement lorsqu'on diminue leur indice de couplage. D'autre part, ces coupleurs présentent une pente importante en fonction de la fréquence radio (typiquement 6 dB/octave), ce qui est inacceptable pour asservir le gain d'un amplificateur large bande.

EP-A-0 604 203 décrit un dispositif de mesure selon le préambule de la revendication 1 ci-annexée. D'autres exemples de coupleurs hybrides directifs sont décrits dans les articles Emery et al., « Analysis and Design of Ideal Non Symmetrical Coupled Microstrip Directional Couplers », IEEE International Microwave Symposium, Long Beach, Juin 1989, Vol. 1, pages 329-332, et P. K. IKÄLÄINEN et al., « Wide-Band, Forward-Coupling Microstrip Hybrids with High Directivity », IEEE Transactions on Microwave Theory and Techniques, Vol. 35, n° 8, Août 1987, New York, USA, pages 719-725.

Un but de la présente invention est de proposer un dispositif de mesure de puissance radiofréquence à faible coût de réalisation, qui présente une large bande de fonctionnement avec un faible niveau d'ondulation dans cette bande, et de bonne précision.

L'invention propose ainsi un dispositif de mesure de puissance radiofréquence comprenant un coupleur asymétrique comportant un substrat isolant sur lequel sont déposées des première et seconde lignes conductrices parallèles de largeurs différentes, un filtre compensateur de pente, et des premier et second réseaux d'adaptation d'impédance sensiblement identiques constitués chacun par une inductance et une résistance en série. La première ligne conductrice du coupleur a une extrémité d'entrée pour recevoir un signal radio et une extrémité de sortie pour transmettre ledit signal radio. La seconde ligne conductrice du coupleur a une première extrémité adjacente à l'extrémité de sortie de la première ligne et reliée au premier réseau d'adaptation d'impédance, et une seconde extrémité adjacente à l'extrémité d'entrée de la première ligne et reliée à l'entrée du filtre compensateur de pente. Le second réseau d'adaptation d'impédance est relié à la sortie du filtre compensateur de pente, et délivre un signal de mesure de la puissance dudit signal radio.

L'utilisation d'un coupleur directif asymétrique permet d'obtenir un bon rapport entre la directivité et le couplage. Les réseaux d'adaptation d'impédance compensent les différences d'impédance dues aux largeurs différentes des lignes conductrices du coupleur et permettent, grâce aux inductances, de compenser les capacités parasites parallèles existant entre les lignes du coupleur. Ce dispositif peut avoir une bonne précision de mesure dans une large bande de fréquence (typiquement 1 octave), le filtre compensateur de pente corrigeant l'augmentation naturelle du couplage avec la fréquence.

D'autre particularités et avantages de la présente invention apparaîtront dans la description ci-après d'un exemple de réalisation non limitatif, en référence aux dessins annexés, dans lesquels :
- la figure 1 est une vue en perspective d'un coupleur radiofréquence utilisable dans un dispositif selon l'invention ;
- la figure 2 montre un étage amplificateur d'un émetteur radio, comportant deux dispositifs de mesure de puissance selon l'invention ; et
- la figure 3 est un schéma d'un filtre correcteur de pente utilisable dans un dispositif selon l'invention.

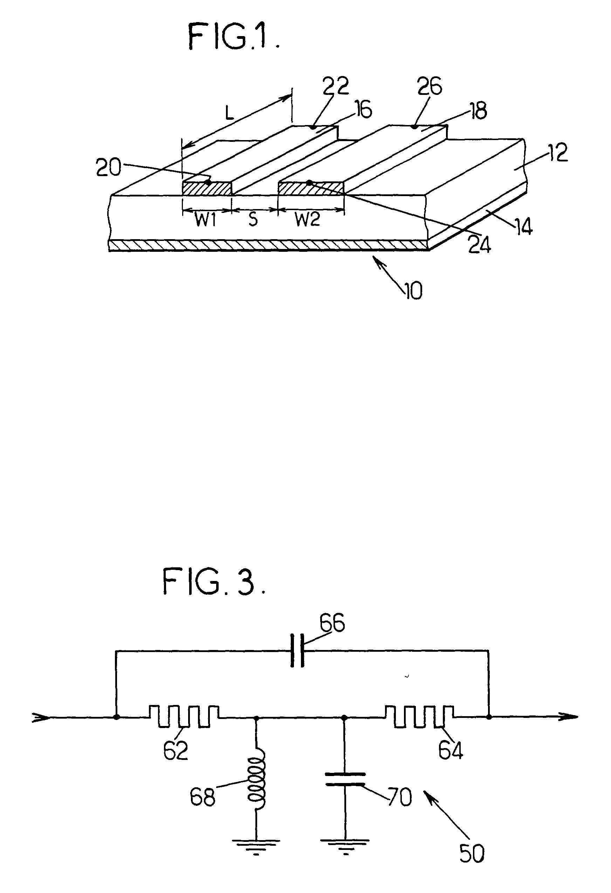

La figure 1 montre un coupleur de type "microstrip" comprenant un substrat isolant 12, par exemple en verre-polytétrafluoroéthylène, dont la face inférieure présente un plan de masse conducteur en cuivre 14, et dont la face supérieure présente deux lignes conductrices parallèles en cuivre 16, 18. Les lignes 16, 18 ont la même longueur L, mais leurs largeurs sont différentes, la largeur W1 de la ligne 16 étant inférieure à la largeur W2 de la ligne 18. Le coupleur 10 comporte quatre accès pour le raccordement à son environnement : deux accès 20, 22 correspondant aux deux extrémités de la ligne 16, et deux accès 24, 26 correspondant aux extrémités de la ligne 18, l'accès 24 étant adjacent à l'accès 20, et l'accès 26 étant adjacent à l'accès 22.

La ligne la moins large 16 du coupleur est prévue pour recevoir à son extrémité 20 un signal radio dont on souhaite mesurer la puissance, et pour transmettre ce signal radio par son extrémité 22.

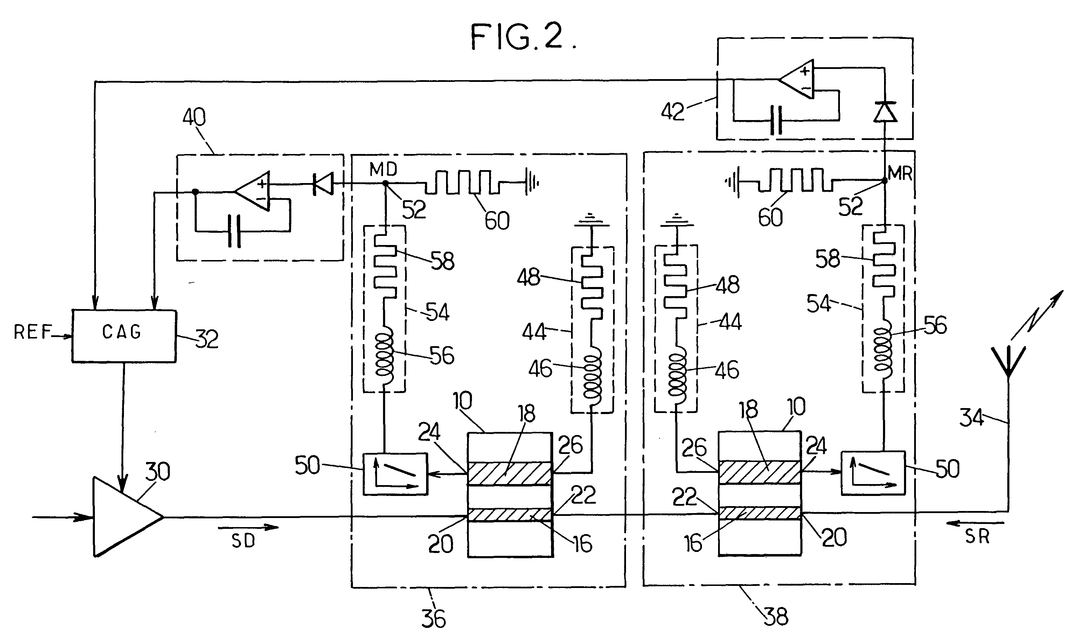

La figure 2 illustre une application de l'invention dans un étage amplificateur d'un émetteur radio . L'amplificateur de puissance 30, dont le gain est commandé par une unité d'asservissement 32, fournit un signal radio amplifié à l'antenne 34. Deux dispositifs de mesure de puissance 36, 38 sont prévus entre la sortie de l'amplificateur 30 et l'antenne 34. Le dispositif 36 mesure la puissance du signal radio direct SD délivré par l'amplificateur 30, tandis que le dispositif 38 mesure la puissance de la composante SR réfléchie par l'antenne 34. Le dispositif 36 est représenté en amont du dispositif 38, mais on comprendra que cet ordre pourrait être inversé.

Le dispositif 36 extrait du signal direct SD une tension de mesure MD qui est convertie en une tension continue par un circuit de conversion 40. Cette tension continue est adressée à l'unité d'asservissement 32 qui, de façon connue, asservit le gain de l'amplificateur 30 pour que cette tension de mesure s'aligne sur une tension de consigne REF. De même, un circuit de conversion 42 convertit la tension de mesure MR extraite de la composante réfléchie SR par le dispositif 38 en une tension continue fournie à l'unité d'asservissement 32. Celle-ci peut alors commander le gain de l'amplificateur 30 de façon à ce que la puissance réfléchie ainsi mesurée ne dépasse pas une valeur prédéfinie au-delà de laquelle l'amplificateur 30 risquerait d'être détérioré.

Les deux dispositifs de mesure 36 et 38 sont essentiellement identiques. Ils ne diffèrent que par les connexions des lignes 16 de leurs coupleurs respectifs : le coupleur 10 du dispositif 36 a son accès d'entrée 20 relié à la sortie de l'amplificateur de puissance 30 pour recevoir le signal direct SD, tandis que le coupleur 10 du dispositif 38 a son accès d'entrée 20 relié à l'antenne 34 pour recevoir la composante réfléchie SR.

L'accès 26 du coupleur 10 de chaque dispositif de mesure 36, 38 est relié à un réseau d'adaptation d'impédance 44 consistant en une inductance 46 et une résistance 48 montées en série entre l'accès 26 et la masse.

L'accès 24 du coupleur 10 est relié à l'entrée d'un filtre compensateur de pente 50, dont la sortie est reliée au noeud 52 où est disponible la tension de mesure MD ou MR par l'intermédiaire d'un autre réseau d'adaptation d'impédance 54. Ce réseau d'adaptation d'impédance 54 est identique au réseau 44, avec une inductance 56 et une résistance 58 montées en série et de caractéristiques aussi proches que possible de celles de l'inductance 46 et de la résistance 48. Le noeud 52 est relié à la masse par l'intermédiaire d'une résistance de charge 60.

La résistance de charge 60 est adaptée à l'impédance caractéristique de l'antenne 34 et de la ligne 16 du coupleur 10 (par exemple 50 Ω). Les résistances 48, 58 des réseaux d'adaptation d'impédance 44, 54 sont adaptées à l'impédance caractéristique de la seconde ligne 18 du coupleur 10 (par exemple 33 Ω).

Le filtre compensateur de pente 50 est de préférence un filtre passif, tel qu'un filtre à structure T-pont-T comme représenté sur la figure 3. Ce filtre T-pont-T se compose de deux résistances 62, 64 connectées en série entre son entrée et sa sortie, en parallèle avec un condensateur 66, et d'une inductance 68 et d'un autre condensateur 70 montés en parallèle entre la masse et le noeud séparant les deux résistances 62, 64. Les caractéristiques de ces composants, ainsi que celles des inductances 46, 56 des réseaux d'adaptation d'impédance sont déterminées en fonction des caractéristiques du coupleur 10 et de la bande passante de fonctionnement, par exemple en utilisant un outil de simulation de circuits radio.

Le dispositif de mesure de puissance selon l'invention a l'avantage d'avoir un faible coût de fabrication. Ses composants sont passifs et peuvent être réalisés sur un même circuit imprimé, le coupleur 10 étant un composant monté en surface, dont les dimensions typiques sont de quelques centimètres parallèlement au substrat et de l'ordre du millimètre en épaisseur. Lorsque deux dispositifs de mesure sont utilisés conjointement, comme dans l'application illustrée par la figure 2, ils peuvent être réalisés sur un seul circuit imprimé.

Bien qu'on ait décrit l'invention dans son application à l'étage de puissance d'un émetteur radio, on comprendra qu'elle peut avoir des applications dans d'autres domaines où des mesures de puissance radiofréquence sont utiles, par exemple pour mesurer le rapport d'onde stationnaire (ROS) dans un quadripôle large bande.

## Revendications

1. Dispositif de mesure de puissance radiofréquence, comprenant un coupleur (10) comportant un substrat isolant (12) sur lequel sont déposées des première et seconde lignes conductrices parallèles (16,18), et un filtre compensateur de pente (50), le dispositif étant réalisé de sorte que la première ligne conductrice (16) du coupleur a une extrémité d'entrée (20) pour recevoir un signal radio (SD ;SR) et une extrémité de sortie (22) pour transmettre ledit signal radio, et que la seconde ligne conductrice (18) du coupleur a une première extrémité (26) adjacente à l'extrémité de sortie (22) de la première ligne et une seconde extrémité (24) adjacente à l'extrémité d'entrée (20) de la première ligne et reliée à l'entrée du filtre compensateur de pente (50), **caractérisé en ce que** le dispositif comprend en outre des premier et second réseaux d'adaptation d'impédance sensiblement identiques (44,54) constitués chacun par une inductance (46,56) et une résistance (48,58) en série, **en ce que** le coupleur (10) est asymétrique, les première et seconde lignes conductrices (16,18) ayant des largeurs différentes, **en ce que** la première extrémité (26) de la seconde ligne conductrice (18) du coupleur est reliée au premier réseau d'adaptation d'impédance (44), et **en ce que** le second réseau d'adaptation d'impédance (54) est relié à la sortie du filtre compensateur de pente (50) et délivre un signal (MD;MR) de mesure de la puissance dudit signal radio.

2. Dispositif selon la revendication 1, **caractérisé en ce que** le coupleur asymétrique (10) a sa première ligne (16) moins large que sa seconde ligne (18).

3. Dispositif selon la revendication 1 ou 2, **caractérisé en ce que** le filtre compensateur de pente (50) est un filtre passif.

4. Dispositif selon la revendication 3, **caractérisé en ce que** le filtre compensateur de pente (50) a une structure T-pont-T.

## Patentansprüche

1. Vorrichtung zur Hochfrequenzleistungsmessung, die einen Koppler (10) mit einem isolierenden Substrat (12) umfasst, auf das parallel zueinander eine erste und eine zweite Leitung (16, 18) sowie ein Kompensationsfilter (50) für die Flankensteilheit aufgebracht sind, wobei die Vorrichtung so ausgeführt ist, dass die erste leitende Leitung (16) des Kopplers ein Eintrittsende (20) zum Empfang eines Funksignals (SD; SR) und ein Austrittsende (22) zur Übertragung des Funksignals aufweist und dass die zweite leitende Leitung (18) des Kopplers ein erstes Ende (26) hat, das an das Austrittsende (22) der ersten Leitung angrenzt, und ein zweites Ende (24), das an das Eintrittsende (20) der ersten Leitung angrenzt und an den Eingang des Kompensationsfilters für die Flankensteilheit (50) gelegt ist, **dadurch gekennzeichnet, dass** die Vorrichtung ferner einen ersten und einen zweiten Impedanzanpassungsschaltkreis (44, 54) umfasst, die im Wesentlichen identisch sind und jeweils von einer Induktivität (46, 56) und einem Widerstand (48, 58), die in Serie geschaltet sind, gebildet werden, dass der Koppler (10) asymmetrisch ist, die erste und zweite Leitung (16, 18) unterschiedliche Breiten aufweisen, dass das erste Ende (26) der zweiten leitenden Leitung (18) des Kopplers an den ersten Impedanzanpassungsschaltkreis (44) gelegt und der zweite Impedanzanpassungsschaltkreis (54) an den Ausgang des Kompensationsfilters für die Flankensteilheit (50) gelegt ist und ein Signal (MD;MR) liefert, das die Leistung des genannten Funksignals misst.

2. Vorrichtung nach Anspruch 1, **dadurch gekennzeichnet, dass** die erste Leitung (16) des asymmetrischen Kopplers (10) schmaler ist als dessen zweite Leitung (18).

3. Vorrichtung nach Anspruch 1 oder 2, **dadurch gekennzeichnet, dass** der Kompensationsfilter für die Flankensteilheit (50) ein passiver Filter ist.

4. Vorrichtung nach Anspruch 3, **dadurch gekennzeichnet, dass** der Kompensationsfilter für die Flankensteilheit (50) ein Doppel-T-Filter ist.

## Claims

1. A radiofrequency power measurement device, comprising a coupler (10) having an insulating substrate (12) on which first and second parallel conducting lines (16,18) are deposited, and a slope compensating filter (50), the device being so arranged that the first conducting line (16) of the coupler has an input end (20) for receiving a radio signal (SD;SR) and an output end (22) for transmitting said radio signal, and that the second conducting line (18) of the coupler has a first end (26) adjacent to the output end (22) of the first line and a second end (24) adjacent to the input end (20) of the first line and connected to the input of the slope compensating filter (50), **characterized in that** the device further comprises first and second substantially identical impedance matching networks (44,54) each consisting of an inductor (46,56) and a resistor (48,58) arranged in series, **in that** the coupler (10) is asymmetric, the first and second conducting lines (16,18) having different widths, **in that** the first end (26) of the second conducting line (18) of the coupler is connected to the first impedance matching networks (44), and **in that** the second impedance matching networks (54) is connected to the output of the slope compensating filter (50) and delivers a signal (MD;MR) for measuring power of said radio signal.

2. A device according to claim 1, **characterized in that** the asymmetric coupler (10) has its first line (16) less wide than its second line (18).

3. A device according to claim 1 or 2, **characterized in that** the slope compensating filter (50) is a passive filter.

4. A device according to claim 3, **characterized in that** the slope compensating filter (50) has a T-bridge-T structure.
